(19)

Europäisches
Patentamt
European
Patent Office
Office européen
des brevets

(11) **EP 3 372 705 A1**

(12) **EUROPEAN PATENT APPLICATION**
published in accordance with Art. 153(4) EPC

(43) Date of publication:
**12.09.2018 Bulletin 2018/37**

(21) Application number: **16862142.3**

(22) Date of filing: **02.11.2016**

(51) Int Cl.:
*C23C 8/36* (2006.01)          *C23C 16/34* (2006.01)
*C23C 16/511* (2006.01)        *C30B 25/18* (2006.01)
*C30B 29/38* (2006.01)         *H05H 1/30* (2006.01)

(86) International application number:
**PCT/JP2016/082629**

(87) International publication number:
**WO 2017/078082 (11.05.2017 Gazette 2017/19)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **04.11.2015 JP 2015216552**

(71) Applicant: **National Institute Of Advanced
Industrial Science
Tokyo 100-8921 (JP)**

(72) Inventors:
• **ITAGAKI Hirotomo
Tsukuba-shi
Ibaraki 305-8568 (JP)**

• **SAKAKITA Hajime
Tsukuba-shi
Ibaraki 305-8568 (JP)**
• **KIM Jaeho
Tsukuba-shi
Ibaraki 305-8568 (JP)**
• **OGURA Mutsuo
Tsukuba-shi
Ibaraki 305-8568 (JP)**
• **WANG Xuelun
Tsukuba-shi
Ibaraki 305-8568 (JP)**
• **HIROSE Shingo
Tsukuba-shi
Ibaraki 305-8564 (JP)**

(74) Representative: **Graf von Stosch, Andreas et al
Graf von Stosch
Patentanwaltsgesellschaft mbH
Prinzregentenstraße 22
80538 München (DE)**

(54) **PRODUCTION METHOD AND PRODUCTION DEVICE FOR NITROGEN COMPOUND**

(57)      [Problem] To provide a method and apparatus for production of a nitrogen compound film by a plasma, wherein the method and apparatus are suitable for area enlargement by a process at a higher pressure with lower power consumption, without applying a voltage to a base material, and without using a large chamber.

[Solution] In nitrogen compound production for producing a nitrogen compound by generating a microwave plasma, in a step of jetting a material gas containing a nitrogen-based gas onto a surface of a base material from a nozzle under flow rate control while applying a microwave to the material gas to thereby irradiate the surface of the base material with a plasma containing nitrogen-based reactive species generated from the material gas, the pressure is set higher than a pressure at which the mean free path of ions in the plasma is shorter than the Debye length.

FIG. 1

EP 3 372 705 A1

**Description**

Technical Field

The present invention relates to a producing method and a producing apparatus for a nitrogen compound using a microwave plasma source.

Background Art

Hitherto, as a method for producing a thin film of a nitrogen compound, there have been known, for example, a method of applying a nitriding treatment to a surface of a base material and a method of forming a nitrogen compound on a surface of a base material by a thin film forming technique.

The nitriding treatment method is one of surface modification treatment methods, and is widely used as a surface modification method for nitriding surfaces of, for example, iron and steel, and titanium. Products to which nitriding surface treatment is applied are used in, for example, machine tool parts such as spindles and gears, internal-combustion engine parts such as turbines and fuel injection nozzles, reduction gears of, for example, power shovels, and aircraft and automobile parts. Further, in recent years, development of nitriding treatment has been made in various fields, including nitriding treatment for medical parts. The nitriding treatment method can be used as a high-density nitrogen-based reactive species supplying method for imparting surface functions such as enhancement of hardness, imparting of corrosion resistance, and imparting of wear resistance.

The high-density nitrogen-based reactive species supplying method of the nitriding treatment method can be applied to generation of materials on surfaces of base materials, such as Metal Organic Chemical Vapor Deposition (hereinafter referred to as MOCVD).

In semiconductor technology fields, blue and green light emitting diodes (LED) formed of GaN-based compound semiconductors have been becoming popular as energy-saving, long-life illumination/display light sources to replace existing illumination devices such as light bulbs and fluorescent lights. In LED illumination devices, a white light synthesizing method of exciting yellow phosphor with a blue LED has been the mainstream. In this case, the theoretical limit of the luminous efficiency of the LED alone is about 270 lm/W. In order to further improve the luminous energy efficiency (theoretical efficiency>400 lm/W), it is necessary to develop a phosphor-free white LED configured to cause multicolor LEDs to emit light simultaneously. The problem is to improve the external quantum efficiency of a green LED formed of, as a light-emitting material, InGaN in which In accounts for about 30%. Currently, green LEDs, even if they are high-performance products, have a luminous efficiency of about 20%, which is equal to or less than a half of the luminous efficiency of blue and red LEDs. The reason for this is that it is desirable to grow In, which is a constituting element of green LEDs, at a low temperature of about 600 degrees C because In has a high vapor pressure, whereas for nitrogen (N), it is necessary to decompose ammonia at a high temperature of 800 degrees C or higher, or desirably 1,000 degrees C or higher to supply nitrogen in an active state, making it difficult to obtain an optimum crystal growth condition. Hence, there is a need for a method that can supply nitrogen-based reactive species at a high density at 800 degrees C or lower.

As a nitriding method, for example, there is known a technique of supplying substantially only an ammonia gas to a gas nitriding furnace and forming a nitride layer on a surface of a member in the ammonia gas and a decomposed gas of ammonia (see PTL 1).

There is also known a glow discharge ion nitriding method that can efficiently form a compound layer of a metal nitride on a surface of a metallic member and also can enhance hardness based on a synergetic effect of the compound layer and a diffusion layer of nitrogen atoms (see PTL 2). In PTL 2, the metallic member is subjected to an ion nitriding treatment at -700 V, at 0.95 A (665 W), using 2 slm of hydrogen and 0.5 slm of ammonia as ion nitriding working gases, at an ambient pressure of 1 Torr, and for 1 hour. During this, with the temperature of the metallic member maintained at from 300 degrees C through 650 degrees C, ion nitriding is applied to the surface of the metallic member with a glow discharge having a current density of from 0.001 mA/cm^2 through 2 mA/cm^2 under a plasma state having an emission intensity ratio of from 0.2 through 0.1 between NH radicals and nitrogen radicals.

A titanium alloy-nitriding thin film synthesizing technique using an atmospheric pressure plasma has been known as an easier nitriding treatment method than existing nitriding methods (see NPL 1). Use of an atmospheric pressure plasma enables simplification of the treatment apparatus, generation of high-density radicals, and suppression of metal surface roughening. In NPL 1, 99% of nitrogen and 1% of a hydrogen gas are used as working gases with a highfrequency power source (5 kV, 1.2 A, and 21 kHz) at an effective power of 4 kilowatts.

Recently, microwave plasma treatment apparatuses capable of stably generating and maintaining plasmas at low pressures, intermediate pressures, and high pressures have been being developed (see NPL 2 and PTL 3). Typically, the properties of plasmas for, for example, plasma CVD treatment are strongly dependent on the pressures at which plasmas are generated. Therefore, plasmas are classified into the following three kinds based on pressure: (1) low-pressure plasmas: a pressure range of from 0.01 Torr through 1.0 Torr, (2) intermediate-pressure plasmas: a pressure range of from 1.0 Torr through 100 Torr, and (3) highpressure plasmas: a pressure range of from 100 Torr through 760 Torr (atmospheric pressure). Note that pressures will hereinafter be expressed in Pa unit (1 Torr = 133 Pa).

The present inventors have already proposed a microwave plasma treatment apparatus that uses as a microwave transmission line, a microstrip line instead of a waveguide (see NPL 2 and PTL 3). This apparatus is advantageous over existing microwave plasma treatment apparatuses using waveguides in, for example, a simpler structure, less costly production, and operation at lower power, and industrial applications of this apparatus in various ways are expected in the future.

Citation List

Patent Literature

PTL 1: Japanese Patent Application Laid-Open (JP-A) No. 2013-249524
PTL 2: JP-A No. 08-035053
PTL 3: International Publication No. WO 2015/030191

Non-Patent Literature

NPL 1: Yuki Yoshimitsu and others, "Synthesis of Nitride Thin Films of Ti-6Al-4V using Atmospheric-Pressure Plasma", the Institute of Electrical Engineers of Japan, plasma researcher's society, PST-14-057 (2014) 1-4
NPL 2: Jaeho Kim et.al, Jpn. J. Appl. Phys. 54, 10AA02 (2015)

Summary of Invention

Technical Problem

Hitherto, nitrogen compound producing methods and base material nitriding treatment methods have had the following problems.

The technique of PTL 1 performs nitriding by heating a gas. Therefore, the amount of the gas to be consumed is high, and about 7.5 $m^3$ or more is required. Further, for example, a large-size chamber having a width of 760 mm, a length of 1,200 mm, and a height of 800 mm is required with respect to a substrate diameter of 30 mm.

The nitriding method using a glow discharge as in PTL 2 needs to perform a plasma treatment in a vacuum and has a problem that the size and cost of the apparatus will be increased along with increase in the size of the nitriding target. There is also a problem that generation of a plasma in a space requires a high power consumption, leading to a poor efficiency. Moreover, because the nitriding target is used as an electrode, there may occur problems that an arc spot (a spot-shaped mark of a discharge) is formed on the nitriding target or that a discharge may transform into a hollow cathode discharge if the nitriding target has a narrow hole.

The technique of NPL 1 has a problem that it can only nitride a range of φ4 at a center temperature for substrate irradiation of about 970 degrees C, resulting in a very small nitrided area. It is difficult to cover a large area because plasma irradiation from a φ4 orifice having a cylindrical structure results in partial nitriding. There is also a problem that a high power is required.

Hitherto, in order to reduce ion bombardment on a base material, typical remote-type plasma treatment methods have been available to perform a treatment by placing the base material remotely from the plasma region. However, the typical remote-type methods have a problem that a nitrogen compound synthesizing speed is low and a long time is required.

A proposal for use of a microwave plasma in a nitrogen compound producing method has been presented in PTL 3. The plasma treatment apparatus of PTL 3 can generate a stable nitrogen plasma at a low power. Nitrogen plasma is expected to be applied to plasma nitriding treatments including, for example, nitriding treatments on surfaces of metals such as copper and production of nitride semiconductors. However, the present inventors have encountered the following problem in the process of research and development on nitrogen compounds. The existing apparatus of PTL 3 has a problem that in production of a nitrogen compound by heating a base material with a heater, there occurs a strong radiant heat and it is difficult to protect the plasma source from the heat.

For green LEDs, it is necessary to grow a crystal of InGaN in which the composition ratio of In is about 30%. However, in order to improve the crystal quality with prevention of re-evaporation and compositional separation (segregation) of In, a growing temperature of 600 degrees C or higher but 700 degrees C or lower is desirable. On the other hand, in order to decompose ammonia, a high temperature (about 800 degrees C) is required. A method for optimally controlling both while decomposing ammonia has not yet been found.

The present invention is intended for solving these problems and has an object to provide a nitrogen compound producing method and apparatus for transforming a nitrogen-based gas (for example, a nitrogen gas or an ammonia gas) into a plasma and irradiating a base material with high-density nitrogen-based reactive species (hereinafter may also be referred to as "nitrogen-based radicals"). The present invention also has an object to provide a producing method and a producing apparatus for a nitrogen compound that can be formed at a lower temperature than by existing methods. The present invention also has an object to provide a producing method and a producing apparatus for a nitrogen compound by a process with a higher pressure and a lower power consumption.

Solution to Problem

The present invention has the following features in order to achieve the objects.

The method of the present invention is a nitrogen compound producing method for producing a nitrogen compound by generating a microwave plasma. In a step of jetting a material gas containing a nitrogen-based gas onto a surface of a base material from a nozzle under flow rate control while applying a microwave to the material gas to thereby irradiate the surface of the base material with a plasma containing nitrogen-based reactive species generated from the material gas, the method is characterized by setting a pressure higher than a pressure at which the mean free path of ions in the plasma is shorter than the Debye length.

In the method of the present invention, for application of the microwave, it is desirable to use a microstrip line or a strip line as a microwave transmission line.

In the method of the present invention, arranging the nozzle to have a line shape makes it possible to irradiate the base material with the plasma in a line shape and form a nitrogen compound in a line shape on the surface of the base material.

In the method of the present invention, in jetting the material gas from the nozzle, the material gas may be jetted at a jetting angle in a range of $\pm 45$ degrees from a plane perpendicular to the base material.

In the method of the present invention, it is preferable to set the pressure at which the step is performed to 1 kPa or higher.

In the method of the present invention, the feeding energy for feeding the microwave is 500 watts or lower.

The method of the present invention is characterized by including a step of arranging 2 or more nozzles in an overlapping manner and jetting the material gas containing the nitrogen-based gas onto the surface of the base material from each of the nozzles under flow rate control while applying a microwave to the material gas to thereby generate a plasma containing nitrogen-based reactive species from the material gas and irradiate the surface of the base material with the plasma.

In the method of the present invention, for example, the base material is Ti and the nitrogen compound is TiN.

The method of the present invention epitaxially grows a thin-film crystal of a nitrogen compound formed of any one of GaN, InGaN, InN, and AlN, and a mixture composition thereof on the base material at a low temperature of 700 degrees C or lower, by transporting, for example, Ga, In, or Al in the form of an organometallic vapor and allowing it to undergo a reaction with the plasma containing the nitrogen-based reactive species generated from the material gas in a gas phase or over a substrate.

The method of the present invention is characterized by providing a nitrogen-based reactive species measuring unit and a control unit to perform control based on measurement of the amount of the nitrogen-based reactive species.

The apparatus of the present invention is an apparatus configured to produce a nitrogen compound by generating a microwave plasma, and includes a chamber, a microwave plasma generating apparatus provided in the chamber and including a nozzle, a nitrogen-based reactive species measuring unit, and a control unit. In a step of jetting a material gas containing a nitrogen-based gas onto a surface of a base material from the nozzle under flow rate control while applying a microwave to the material gas to thereby irradiate the surface of the base material with a plasma containing nitrogen-based reactive species generated from the material gas, the control unit is characterized by controlling the pressure in the chamber to be higher than a pressure at which the mean free path of ions in the plasma is shorter than the Debye length, based on measurement of the amount of the nitrogen-based reactive species.

Advantageous Effects of Invention

The method of the present invention is a remote-type method of, for generation of a nitriding plasma, applying a strong electric field as a microwave to, for example, the vicinity of the leading end of the nozzle to transform a nitrogen-based gas (for example, a nitrogen gas or an ammonia gas) into a plasma state and irradiate a base material with high-density nitrogen-based reactive species. It is possible to flow the nitrogen-based gas while mixing it with a gas of, for example, hydrogen, helium, or argon. Because the method is a remote type, there is no need of directly applying a voltage to the nitriding target, and a fundamental resolution to the generation of a spot-shaped mark of a discharge due to, for example, arcing can be obtained. The present invention can also realize downsizing and weight saving of a nitriding apparatus and a nitrogen compound producing apparatus. The present invention can also realize a feeding energy of 500 watts or lower, or even 200 watts or lower for feeding a microwave. Hence, the present invention can significantly save power consumption compared with existing techniques. Moreover, in the method of the present invention, a nitriding treatment or production of a nitrogen compound can be performed at a base material temperature of 800 degrees C or lower.

A nitride film produced by application of a nitriding treatment to a base material, which is the method of the present invention, exhibited excellent properties such as hardness.

Even in production of a nitrogen compound film that hitherto has been difficult to produce, film formation at a low growing temperature of lower than 800 degrees C, or more preferably 600 degrees C or higher but 700 degrees C or lower can be realized with a crystal growing method such as MOCVD, if nitrogen-based reactive species are supplied by the high-density nitrogen-based reactive species supplying method of the present invention.

The method of the present invention can supply high-density nitrogen-based reactive species to a base material in a line shape, and can cover a large area only by arranging a plurality of plasma sources in parallel. Furthermore, optionally, the base material can be easily moved by, for example, back-forth or left-right moving or rotation. This enables uniform nitriding on the surface of the base material.

The plasma source of the present invention is a stable plasma source at about 10 kPa, which is a common pressure in crystal growing by MOCVD. In the present invention, use of this stable plasma source to decompose ammonia and transport nitrogen-based reactive species to the vicinity of the substrate with a carrier gas, while supplying group III elements such as In and Ga in the form of organometals such as TEIn (triethyl indium) and TMGa (trimethyl gallium) can realize low-temperature growing of, for example, InGaN nitride needed in, for example, green LEDs.

Brief Description of Drawings

FIG. 1 is an exemplary diagram of a microwave plasma nitriding apparatus used in an embodiment of the present invention;
FIG. 2A is an exemplary diagram illustrating a collision-free sheath between a plasma and a surface of a base material, exemplarily illustrating a state of ion bombardment from a plasma on the surface of a substrate in a collision-free sheath;
FIG. 2B is an exemplary diagram illustrating a collision sheath between a plasma and a surface of a base material, exemplarily illustrating a state of ion bombardment from a plasma on the surface of a substrate in a collision sheath;
FIG. 2C is a diagram exemplarily illustrating a method of an embodiment of the present invention;
FIG. 3 is a diagram illustrating luminescence of high-density nitrogen-based reactive species generated between a nozzle and a base material in an embodiment of the present invention;
FIG. 4A is a diagram illustrating a photographic image of a surface of a titanium base material before a nitriding treatment of an embodiment of the present invention;
FIG. 4B is a diagram illustrating a photographic image of the surface of the titanium base material after the nitriding treatment of an embodiment of the present invention;
FIG. 5 is a graph plotting Raman spectroscopic spectra of a surface of a titanium base material before and after a nitriding treatment of an embodiment of the present invention;
FIG. 6 is a graph plotting X-Ray diffraction (XRD) analyses on a surface of a titanium base material before and after a nitriding treatment of an embodiment of the present invention;
FIG. 7 is an exemplary diagram of a treatment method of an embodiment of the present invention in which a nozzle is inclined with respect to a base material; and
FIG. 8 is an exemplary diagram illustrating a multiple nozzle-type large area nitriding treatment method or a nitrogen compound film forming method of an embodiment of the present invention.

Description of Embodiments

The embodiments of the present invention will be described below.
The present invention relates to a remote-type method of, for generation of a nitriding plasma, applying a strong electric field to the vicinity of the leading end of a nozzle by means of a microwave to transform a nitrogen-based gas (for example, a nitrogen gas or an ammonia gas) into a plasma state and irradiate a base material with high-density nitrogen-based reactive species.

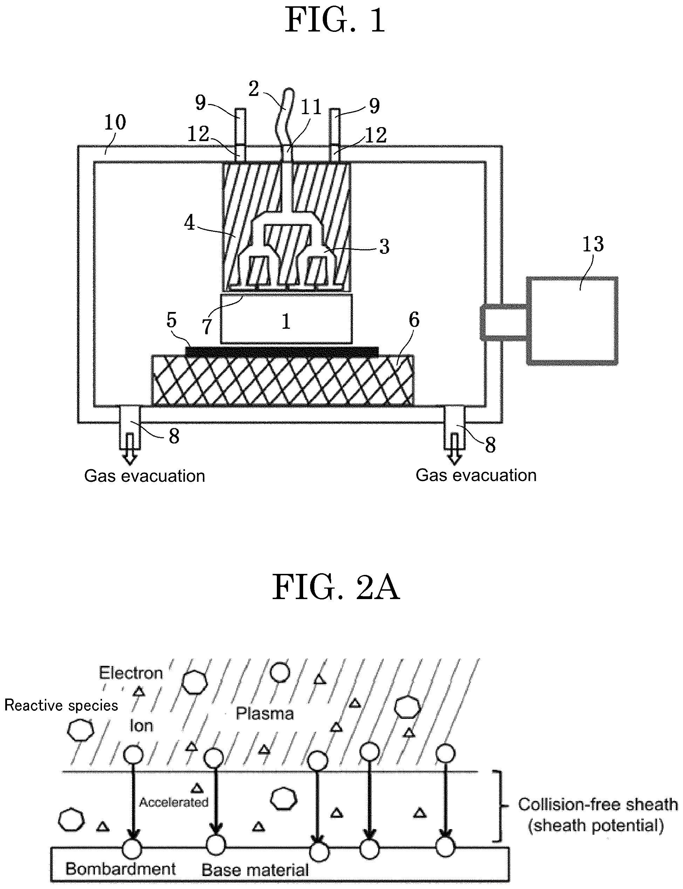

FIG. 1 is an exemplary diagram of an example of an apparatus used in a microwave plasma nitriding method according to an embodiment of the present invention. A microwave plasma nitriding apparatus of FIG. 1 includes a chamber (10) and a microwave plasma generating apparatus provided in the chamber (10). The microwave plasma generating apparatus includes a dielectric substrate (4) provided with a gas flow path therein and with a conductive surface on the back surface thereof, a microstrip line (3) provided on a surface of the dielectric substrate (4), a nozzle (7) provided at one end surface of the dielectric substrate (4), a microwave introducing flange (11) and a coaxial cable (2) that are configured to supply a microwave into the microwave plasma generating apparatus, and a gas introducing flange (12) and a gas introducing pipe (9) that are configured to supply a gas into the microwave plasma generating apparatus. The microwave introducing flange (11) and the gas introducing flange (12) are attached on the chamber (10).
For example, the nozzle (7) has a slit shape in order to enable wide, uniform jetting of a plasma generated by application of a microwave, together with a material gas. In the chamber (10), a plasma CVD treatment was performed in a state that a base material (5) was set immediately below the nozzle (7) of the microwave plasma apparatus in a manner that the width of the nozzle was aligned in the longer direction of the base material. For use, the distance between the nozzle (7) and the base material (5) is adjusted to a predetermined distance. The chamber (10) includes a gas evacuation pipe (8). The region denoted by (1) in FIG. 1 is a space between the nozzle (7) and the base material (5), and is a high-density nitrogen-based reactive species region (1) to be described below in detail. An reactive species measuring unit configured to measure the region may be installed in the chamber (10) in order to obtain information on the nitrogen-based reactive species in the high-density nitrogen-based reactive species region (1), which is a space between the nozzle (7) and the base material (5).

Increase in the pressure in the chamber of the microwave plasma nitriding apparatus shortens the mean free path of nitrogen-based reactive species such as nitrogen atoms and NH molecules and increases the amount of nitrogen-based reactive species near the base material immediately below the nozzle, leading to improvement of the uniformity of nitriding immediately below the nozzle. In this case, any one or both of increasing the microwave power and increasing the treatment time enable(s) nitriding by a uniform remote plasma to be applied in a broader range beyond the range immediately below the nozzle.

However, existing remote plasma methods have a problem that a nitrogen compound synthesizing speed is low and a long time is required.

In the present invention, the pressure in the chamber is set so sufficiently high as to make the mean free path of ions shorter than the Debye length. Generally, the length of a sheath to be formed between a plasma and a wall surrounding the plasma is about the Debye length.

Hence, a collision sheath can be formed between the plasma and the base material, and ions from the plasma collide with other particles in the sheath and lose their kinetic energy. As a result, ions are reduced over the surface of the base material and high-density nitrogen-based reactive species are supplied to the surface of the base material together with the gas flow from the nozzle.

Hence, as a pressure condition to be used in the present invention for a plasma nitriding treatment and production of a nitrogen compound by plasma CVD, a pressure higher than a pressure at which the mean free path ($\lambda_M$) of ions in the plasma is shorter than the Debye length ($\lambda_{De}$) is preferable. Specifically, as a pressure condition for a plasma CVD treatment, 1 kPa or higher is desirable.

A hitherto known mean free path ($\lambda_M$) of ions in a plasma will be described below.

The mean free path of ions is a mean distance travelled by ions between when ions collide with other particles and when ions next collide with other particles. That is, the mean free path is a mean distance travelled by ions without collision. The mean free path ($\lambda_M$) is calculated according to formula (1), formula (2), and formula (3) below.

$$\lambda_M = \frac{1}{n\sigma^2} \qquad (1)$$

Here, n represents the density ($m^{-3}$) of particles, and $\sigma$ represents a collision cross-section ($m^2$).

The collision cross-section is expressed as follows.

$$\sigma = \pi D^2 \qquad (2)$$

Here, D represents the diameter of particles.

The following is a gas state equation.

$$P = nKT \qquad (3)$$

P represents pressure (Torr), k represents Boltzmann's constant ($1.381 \times 10^{-23}$ J/K), and T represents temperature (K).

When formula (2) and formula (3) are applied to formula (1), the mean free path of particles is established as follows.

$$\lambda_M = \frac{1}{\pi}\frac{kT}{D^2 p} \qquad (4)$$

From formula (4), it can be seen that the mean free path of ions is inversely proportional to the pressure. As the pressure increases, the mean free path of ions shortens.

On the other hand, the Debye length ($\lambda_{De}$) is calculated according to formula below.

$$\lambda_{De} = \sqrt{\frac{\varepsilon_0 T_e}{e n_e}} \qquad (5)$$

Here, $\varepsilon_0$ represents free space dielectric constant, $T_e$ represents electron temperature (eV), $n_e$ represents electron density ($m^{-3}$), and e represents elementary charge. Accordingly, the Debye length is determined by electron density and electron temperature.

In the nitrogen compound producing method of the present invention, it is desirable to make a gas flow directly impinge on the surface of the base material, by setting the pressure condition during production to a pressure higher than a pressure at which the mean free path of ions is shorter than the Debye length and jetting a material gas containing a nitrogen-based gas onto the surface of the base material from the nozzle through the plasma region.

A detailed description will be provided below with reference to the drawings.

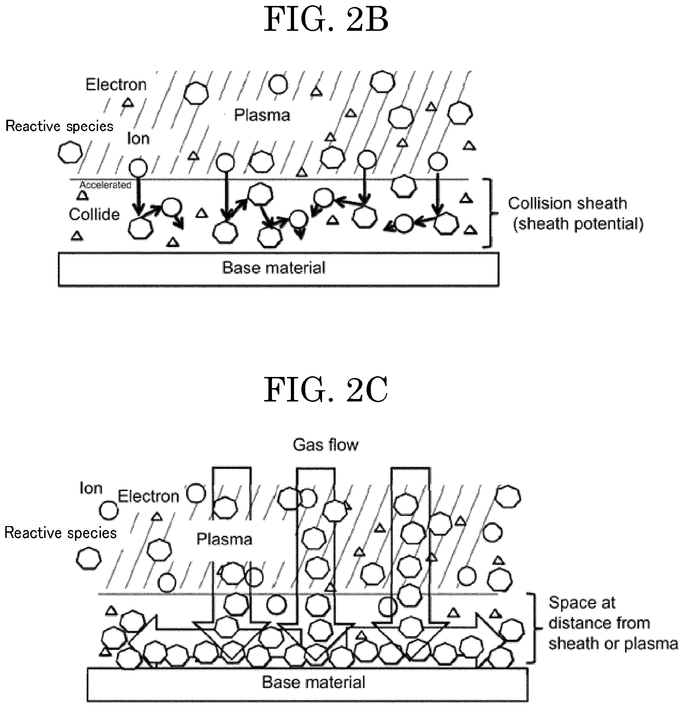

FIG. 2A and FIG. 2B exemplarily illustrate states of ion bombardment from the plasma on the surface of the base material in a collision-free sheath and in a collision sheath, respectively. FIG. 2C exemplarily illustrates the effect of a gas flow impinging on the surface of the base material in the method of the present invention. In the drawings, the plasma region is expressed with hatching. In the drawings, the plasma state is expressed exemplarily by means of electrons (triangles), ions (circles), and nitrogen-based reactive species (for example, heptagons). In the drawings, arrows indicate migration of particles.

First, ion bombardment on the surface of the base material in a collision-free sheath and in a collision sheath will be briefly described below.

(1) Ion bombardment on base material in collision-free sheath (see FIG. 2A)

A typical low-pressure plasma forms a collision-free sheath between the plasma and the surface of the base material. When ions generated in the plasma enter the sheath from the plasma, the ions are accelerated toward the surface of the base material by the sheath potential. At a low pressure, the number of particles in the space is low. Therefore, the accelerated ions impinge on the surface of the base material while keeping a high energy. As a result, in a CVD treatment using a low-pressure plasma, the surface of the base material receives ion bombardment.

(2) Ion bombardment on base material in collision sheath (see FIG. 2B)

Typically, a plasma having a high pressure equal to or higher than intermediate pressures (strictly, a pressure higher than a pressure at which the mean free path of ions is shorter than the Debye length) forms a collision sheath. When ions generated in the plasma enter the sheath from the plasma, the ions are accelerated toward the surface of the base material by the sheath potential. However, at a high pressure, the density of, for example, neutral particles in the sheath is high. Therefore, the ions being accelerated repeatedly collide with these particles. This suppresses acceleration of the ions, to make the kinetic energy of the ions reaching the surface of the base material low. As a result, in a CVD treatment using a plasma having a pressure equal to or higher than an intermediate pressure, ion bombardment on the surface of the base material is drastically suppressed.

These collision sheath and collision-free sheath have already been known.

The effect of a gas flow impinging on the surface of the base material in the method of the present invention illustrated in FIG. 2C will be briefly described.

In the nitrogen compound producing method of the present invention, as illustrated in FIG. 2C, the material gas is jetted toward the surface of the base material, which forcibly sends out the flow of the material gas through the plasma region to directly impinge on the surface of the substrate. As a result, reactive species generated upon a discharge are transported to the surface of the base material together with the flow of the material gas. Further, the gas impinging on the surface of the base material flows along the surface of the base material. Therefore, the reactive species transported to the surface of the base material is further transported along the surface of the base material together with the flow of the gas. As a result, the reactive species are forcibly diffused over the surface of the substrate.

The flow velocity of the gas impinging on the surface of the base material during the plasma CVD treatment can be controlled by changing, for example, the flow rate of the gas supplied, the pressure in the chamber, the distance from the nozzle to the surface of the base material, and the cross-sectional area of the nozzle.

By providing an reactive species measuring unit as illustrated in FIG. 1 in the nitrogen compound producing apparatus suitable for the method of the present invention, it is possible to measure nitrogen-based reactive species in the region of FIG. 2C. For example, luminescence of nitrogen-based reactive species may be spectroscopically measured, to qualitatively or quantitatively evaluate the amount of the nitrogen-based reactive species. Furthermore, a reference value may be set for the amount of the nitrogen-based reactive species, and the amount of the nitrogen-based reactive species may be controlled to be lower or higher than the reference value. This makes it possible to supply nitrogen-based reactive species to the surface of the base material in an amount better suited to the intended process.

As the material gas, a gas containing a nitrogen-based gas is used.

Further, the material gas is used in a state mixed with an inert gas (for example, argon or helium) depending on the condition for plasma generation. By mixing an inert gas, it is possible to stably maintain a plasma even at a high pressure.

Moreover, there may be a case where the material gas is used in a state mixed with an appropriate amount of a hydrogen gas depending on the condition for performing plasma CVD.

The gas is jetted to the surface of the base material through the nozzle provided in the chamber. The nozzle is provided above the surface of the base material, so that the flow of the material gas may directly impinge on the surface of the base material. A plasma is generated by applying a microwave to the interior of the nozzle, or the interior and the end or vicinity of the nozzle.

In the present invention, even when the base material is set at a distance from the plasma generation region, it is possible to supply reactive species necessary for producing a nitrogen compound to the surface of the base material sufficiently, by imparting an appropriate force to the flow of the material gas to be jetted out from the nozzle to impinge on the surface of the base material. This makes it possible to form a film of a nitrogen compound with few flaws at a high speed even over a place that is at a distance from the plasma generation region.

Moreover, by appropriately adjusting the flow velocity of the material gas and the direction of the flow of the gas to impinge on the surface of the base material, it is possible to improve uniformity of film formation.

The nitriding treatment method of the present invention can also be worked on a base material formed of, for example, stainless steel, in addition to the example of TiN described below.

Further, the technique of the high-density nitrogen-based reactive species supplying method of the nitriding treatment method can be applied to generation of a nitrogen compound film over the surface of the base material by, for example, MOCVD. The nitrogen compound producing method of the present invention is particularly useful for production of a thin film of a nitrogen compound formed of any one of GaN, InGaN, InN, or AlN, and a mixture composition of these. That is, it is possible to epitaxially grow a thin film of a nitrogen compound formed of any one of GaN, InGaN, InN, and AlN, and a mixture composition of these on the base material at a low temperature of 700 degrees C or lower, by transporting Ga, In, or Al in the form of an organometallic vapor and allowing it to undergo a reaction with a plasma rich in nitrogen-based reactive species generated from the material gas in a gas phase or over a substrate.

The microwave plasma nitriding method of the present invention and the apparatus used in the method will be specifically described below.

The nozzle may have various shapes such as a rectangular shape, a circular shape, or a medium shape between a rectangular shape and a circular shape. An elongate slit shape is desirable.

In a microwave plasma apparatus at a high pressure, when the nozzle has a large cross-sectional area, there occurs a strong energy coupling between the electric field of a microwave and a plasma, to make the temperature of the plasma high. In order to obtain a stable low-temperature plasma even at a high pressure, it is desirable to generate a microplasma. A microplasma refers to a plasma generated in a space in which the length of the discharge gap is 1 mm or shorter.

In the present invention, in order to generate a microplasma using a microwave, it is preferable to provide the nozzle on a surface perpendicular to the direction of microwave propagation and provide a size of 1 mm or less to a nozzle opening in a direction (vector direction) in which the electric field of a microwave is applied.

Accordingly, in the present invention, in order to stably generate a microplasma using a microwave and realize a large-area process region, it is desirable to use as a nozzle shape, an elongate slit shape having a clearance of 1 mm or less.

A microwave for generating a plasma encompasses a power source having a frequency in a range of from 900 MHz through 5 GHz. The waveform of the microwave may be a continuous wave or a pulse wave.

In the present invention, a microstrip line or a strip line is used as a microwave transmission line for applying a microwave to the nozzle. Use of a microstrip line or a strip line as a microwave transmission line makes it possible to concentrate the electric field of a microwave locally to the position of the nozzle and generate a low-temperature plasma even at a high pressure.

Further, the microstrip line or the strip line and the nozzle are provided on a plate-shape dielectric substrate. Therefore, a plurality of sets of these members can be formed in an array. This makes it possible to enlarge the scale of the plasma CVD treatment area.

Here, a microstrip line is one kind of a transmission line that has a structure obtained by forming a conductive line on a surface of a dielectric substrate having a conductive back surface and that is configured to propagate an electromagnetic wave. A strip line is one kind of a transmission line that has a structure obtained by forming a conductive foil on the front surface and back surface of a dielectric body and forming a conductive line in the dielectric body and that is configured to propagate an electromagnetic wave.

In the present invention, an ordinary waveguide can be used as a microwave transmission line. When a waveguide is used, structurally, the region to be treated by plasma CVD will be treated in the form of spots, and a plasma CVD treatment can be applied to a narrow region in the form of spots. However, it is difficult to enlarge the scale of the plasma CVD treatment area, and such a treatment has a limitation as an industrial mass production technique.

For example, using a rectangular waveguide, a microwave plasma having a jetting type shape can be generated. With a gas tube that is formed of, for example, quartz provided in the waveguide in a manner to vertically penetrate the waveguide, a plasma is generated by concentrating the electric field of a microwave into the gas tube or to the nozzle. The diameter of the nozzle that can be used is determined by the wavelength of a microwave in the waveguide. When 2.45 GHz is used, the diameter of the nozzle is 10 mm or less. If the diameter of the nozzle is equal to or greater than that, it is difficult to generate a plasma. In this example, it is structurally difficult to provide the nozzle in the form of an array. Therefore, it is difficult to enlarge the scale of the plasma nitriding treatment area.

In the present embodiment, a measure is taken to prevent overheating or heat damage of the plasma source, in order to protect the plasma source from the radiant heat mentioned above. For example, as a cooling mechanism, it is possible to employ a structure configured to dissipate heat of the plasma source acquired from the radiant heat from the heater to the outside of the chamber through the chamber. Specifically, the plasma source may be provided to have contact with a part of the chamber. More specifically, the plasma source refers to a microwave plasma generating apparatus including, for example, a dielectric substrate, a microstrip line, and a nozzle.

The present embodiment of the invention is not particularly limited in terms of, for example, a base material temperature, a gas flow rate, and a treatment time. It is possible to perform a nitriding treatment and production of a nitrogen compound at a low temperature (a base material temperature of 800 degrees C or lower). The present embodiment of the invention includes a step of setting an ambient pressure to 1 kPa or higher. Further, in the present embodiment of the invention, for example, the flow rate of the nitrogen-based gas may be set to from 1 L/min through 5 L/min, and the plasma irradiation on the base material may be performed for 2 hours or shorter.

In the present embodiment of the invention, it is possible to produce a nitride layer with a large area continuously, by irradiating the base material with high-density nitrogen-based reactive species while moving the base material continuously or intermittently back and forth, or rotationally.

(Embodiment 1)

In the present embodiment, a titanium metal was used as a base material, and a microwave plasma generating apparatus capable of generating a plasma having a jetting type shape was set in the chamber, to perform nitriding of the surface of the base material at a pressure of 1 kPa or higher. The nitriding method used in the present embodiment will be described below in detail.

In the present embodiment, the apparatus illustrated in FIG. 1 is used. The microwave plasma generating apparatus is disposed in the chamber (10) formed of a metal. The nozzle (7) is a linear rectangular nozzle provided at one end surface of the dielectric substrate (4). The nozzle (7) has a slit shape in order to enable wide, uniform jetting of a plasma generated by application of a microwave, together with a material gas.

In the present embodiment, a method for protecting the plasma source from the radiant heat mentioned above is employed. In the present embodiment, as a cooling method, the plasma source is provided to have contact with a part of the chamber as illustrated in FIG. 1, to thereby dissipate heat of the plasma source acquired from the radiant heat from the heater to the outside of the chamber through the chamber. In this way, the plasma source is prevented from overheating and heat damage.

(Example 1)

One Example of the present embodiment was worked with the use of nozzle having a slit shape and a cross-section having a width of 50 mm and a clearance of 0.5 mm. In the chamber (10), a titanium base material (5) having a thickness of 1 mm and a size of 25 mm × 25 mm was set immediately below the nozzle (7) of the microwave plasma generating apparatus in a manner that the width of the nozzle was aligned in the longer direction of the base material, and a plasma CVD treatment was applied to the titanium base material. The procedures for the treatment were as follows.

The titanium base material (5) was set on a base material table (6) provided in the chamber (10). The height of the base material table (6) was adjusted such that the distance between the nozzle (7) and the titanium base material (5) would be 3 mm. Next, the chamber (10) was evacuated through the gas evacuation pipe (8).

Next, a nitrogen gas was introduced at a rate of 2 L/min into the chamber (10) through the gas introducing flange (12), the gas introducing pipe (9), the gas flow path (unillustrated) in the dielectric substrate (4), and the nozzle (7). The pressure in the chamber (10) was maintained at 2.66 kPa with a pressure adjusting valve coupled to the gas evacuation pipe (8).

Next, a microwave (having a power of 60 W) was introduced through the microwave introducing flange (11) and the coaxial cable (2). The microwave was propagated through the dielectric substrate (4) in which the microstrip line (3) was provided, and applied to the interior of the nozzle (7) provided at the end of the dielectric substrate (4), or to the interior of the nozzle (7) and the end of the nozzle (7), to generate a plasma.

The plasma was generated based on the material gas (nitrogen gas), and high-density nitrogen-based reactive species were diffused toward the titanium base material (5) together with the flow of the material gas. The region to which the nitrogen-based reactive species were diffused was the high-density nitrogen-based reactive species region (1) illustrated in FIG. 1 and located in the space between the nozzle (7) and the titanium base material (5). The treatment time was 1 hour, and the temperature of the base material table on which the base material was set was 800 degrees C.

In the direction of the slit of the nozzle, the plasma generation region had a size of almost 50 mm. Luminescence jetted from the nozzle (7) reached the surface of the base material.

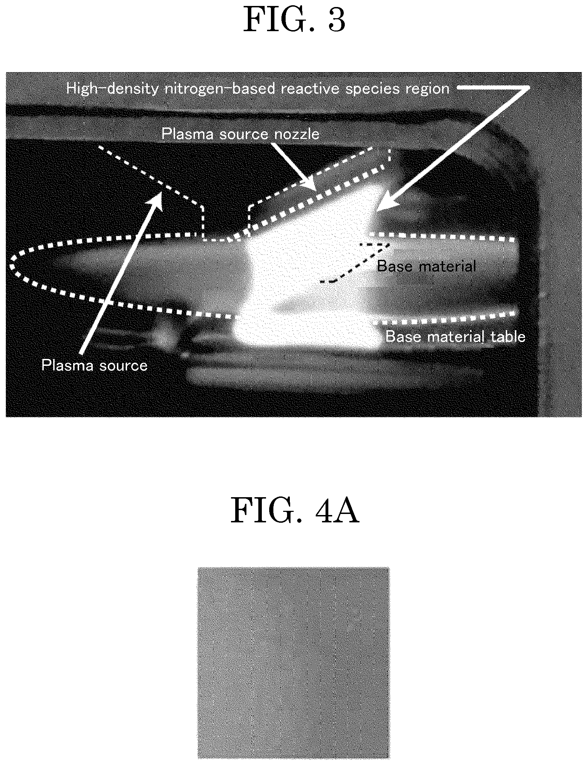

FIG. 3 illustrates a photographic image of the plasma generated under the conditions of Example 1. In the drawing, luminescence is recognized in the space between the base material disposed over the base material table and the nozzle of the plasma source. From the result of a spectroscopic measurement, it was confirmed that nitrogen atoms and nitrogen-based reactive species were generated. From this fact, generation of a high-density nitrogen-based reactive species region (1) was successfully confirmed.

Hence, it was confirmed that a uniform nitrogen compound was generated with a short period of time of plasma treatment, according to the method of the present invention for generating a uniform high-density nitrogen-based reactive species region from the plasma source to the surface of the base material at an intermediate level or higher gas pressure (1 kPa or higher), without a need for direct application of a voltage to the base material, and at a microwave feeding energy of 500 watts or lower (in the present Example, an even lower level of 60 watts or lower was realized), and irradiating the base material with the generated nitrogen-based reactive species.

(Example 2)

As one Example of the present embodiment, a nitriding treatment was applied on a titanium base material with the same apparatus as in Example 1.

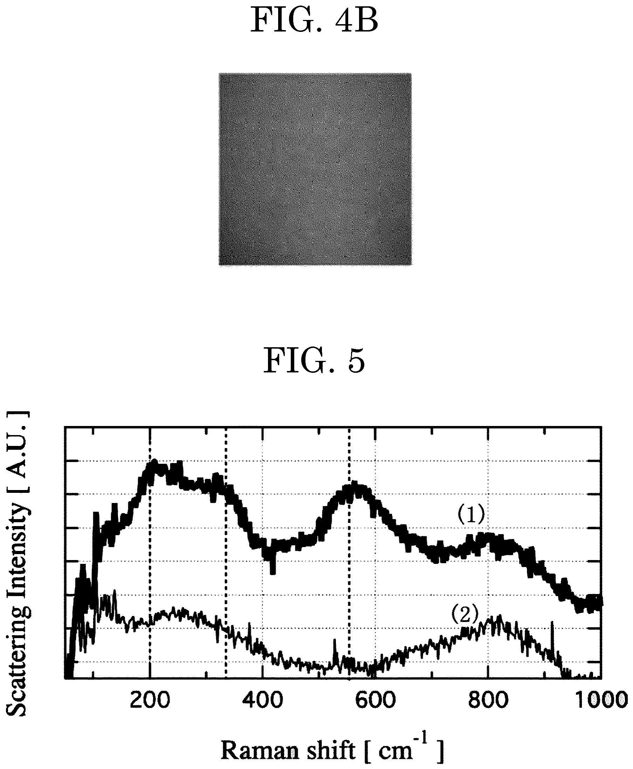

FIG. 4A and FIG. 4B illustrate photographic images of the titanium surface before and after the nitriding treatment, respectively. It can be seen that the titanium surface became golden and was uniformly treated through the nitriding treatment. Here, having become golden means having been nitrided. Conditions for generation in the present Example include a microwave power of 100 watts, a gas pressure of 2.66 kPa, a nitrogen gas flow rate of 1 L/min, a treatment time of 1 hour, the temperature of the base material table on which the base material was set of 800 degrees C, and a distance of 3 mm between the nozzle (7) and the titanium base material (5).

FIG. 5 plots measurement results of Raman spectroscopic spectra of the nitride layer obtained in the present Example, where the spectra were measured with a microscopic Raman spectrometer (RENISHAW). In the graph, (1) represents the result after a plasma nitriding treatment and (2) represents the result before the plasma nitriding treatment. From the graph, typical peaks of TiN were confirmed at 200 cm$^{-1}$, 330 cm$^{-1}$, and 550 cm$^{-1}$.

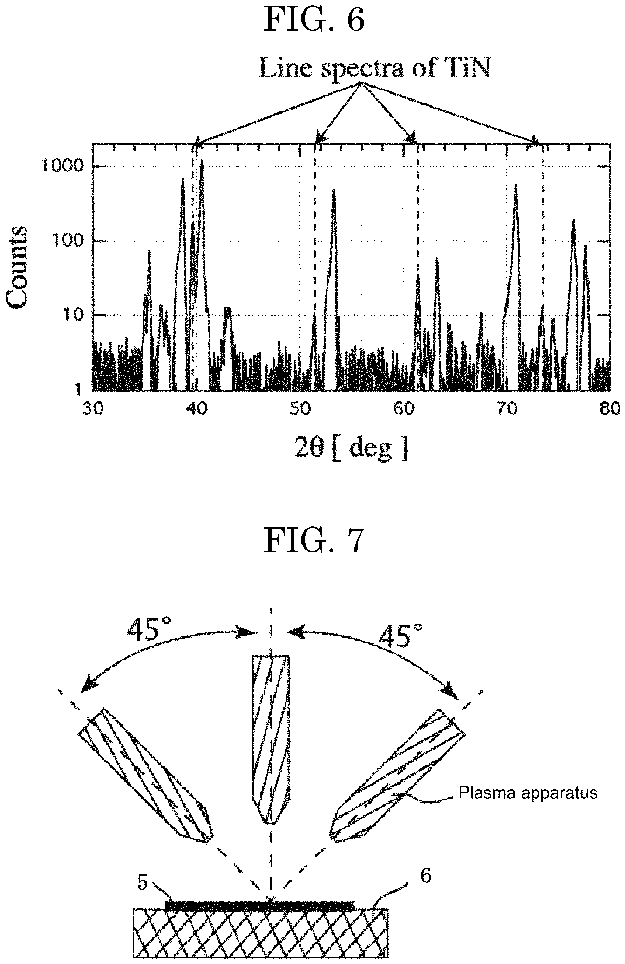

FIG. 6 plots measurement results of X-Ray diffraction (XRD) on the nitride layer obtained in the present Example. From the measurement results, TiN peaks were confirmed.

(Example 3)

As one Example of the present embodiment, a nitriding treatment was applied on a titanium base material with the same apparatus as in Example 1. In the present Example, the nitriding treatment was applied at 2.66 kPa and at 60 watts. The hardness of the titanium surface after the nitriding treatment was measured with a nano indentation tester (ELIONIX ENT1100A (instrument name)) according to a nano indentation method. As a result, the titanium surface had a Martens hardness of 16 GPa, which was a hardness comparable to a hardness obtained by existing nitriding methods. Accordingly, it was possible to provide a nitriding treatment method that exhibited a comparable level of hardness at a significantly low power consumption of one tenth or less, compared with the existing techniques.

(Embodiment 2)

In the present embodiment, a nitriding treatment was applied on a titanium base material with the same apparatus as in the embodiment 1 except for the angle of the nozzle. In the present Example, jetting was performed with the nozzle angle inclined with respect to the base material.

FIG. 7 illustrates an exemplary diagram of the nitriding method of the present Example. The diagram illustrates a case where the nozzle was disposed at an inclined angle of 45 degrees from the normal to the base material, so that the base material may be irradiated with nitrogen-based reactive species from the nozzle at an incident angle of 45 degrees. Inclining the nozzle has the effects of shifting the regions to be irradiated with the generated nitrogen-based reactive species, and suppressing diffusion of the nitrogen-based reactive species due to an organometallic vapor gas flow of Ga, In, or Al. The inclination angle is preferably in the range of ±45 degrees.

(Embodiment 3)

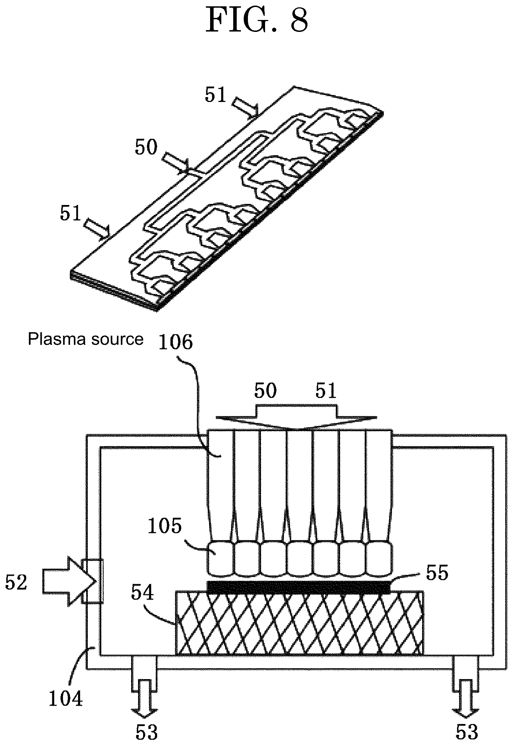

The present embodiment relates to a nitrogen compound producing method that can adapt to a large area treatment. FIG. 8 illustrates a multiple nozzle-type apparatus for a large area. Multiple nozzles, each of which was the same as in the apparatus of the embodiment 1, were arranged in a line shape side by side. As illustrated in FIG. 8, microstrip lines and gas flow paths were formed in an array to provide a plurality of plasma sources (106) configured to generate plasmas at slot-shape nozzles having a length of 200 mm, to thereby realize a large plasma treatment area. The plurality of plasma sources were installed in parallel on the upper surface of a metallic chamber for a large area. A base material (55) was set on a back and forth movable, rotatable, and temperature-adjustable base material table (54) that was provided in the chamber (104) for a large area and on which a base material can be set. The chamber was provided with gas evacuation portions (53). In the upper part of the drawing, the structure of one plasma source (106) is illustrated. A gas 1 (51) and a microwave (50) were supplied to the upper portion of the plasma source. With the plasma source provided to have contact with a part of the chamber, heat of the plasma source acquired from radiant heat from a heater was dissipated to the outside of the chamber through the chamber, to thereby prevent the plasma source from overheating and heat damage.

As a material gas (gas 1 (51)), a nitrogen-based gas was supplied to each plasma source through a gas introducing portion. As needed, a gas 2 (52) (an organometallic gas of, for example, TEIn or TMGa) was supplied through a different position of the chamber. The pressure in the chamber (104) for a large area was maintained at 1 kPa or higher with control of a pressure adjusting valve. A microwave power was applied to each plasma source, to perform treatment with a nitrogen-based reactive species region (105) jetted from the nozzle.

In order to grow a crystal of InGaN in a gas pressure range of about 10 kPa commonly used in crystal growing by MOCVD, it is necessary to supply nitrogen-based reactive species to where a crystal is to be grown, in the mentioned gas pressure range. The apparatus illustrated in FIG. 8 enabled epitaxial crystal growing on a base material by MOCVD. In the present embodiment, the gas 1 (51) illustrated in FIG. 8 was supplied and the gas 2 (52) was also supplied to allow nitrogen-based reactive species generated from the gas 1 (51) to undergo a chemical reaction with the gas 2 (52) to be vapor deposited on the base material (55). For example, using the plasma sources stable at an air pressure of about 10 kPa, ammonia (gas 1 (51)) was supplied and decomposed to transport nitrogen-based reactive species together with a carrier gas (gas 1 (51)) to the vicinity of the substrate, while a group III element such as In or Ga was supplied in the form of an organometal (gas 2 (52)) such as TEIn (triethyl indium) or TMGa (trimethyl gallium), to thereby grow, at a low temperature, InGaN nitride needed in, for example, green LEDs. MOCVD of the present invention enabled film formation at a low temperature by generation of a nitrogen-based plasma excellent in longtime stability, temperature resistance, an reactive species generation property, and planar uniformity.

(Embodiment 4)

The present embodiment relates to an apparatus and method for a case where an reactive species measuring unit (13) was provided as illustrated in FIG. 1. By providing the reactive species measuring unit, it was possible to measure the amount of nitrogen-based reactive species in the region of FIG. 2C. Furthermore, a reference value was set for the amount of the nitrogen-based reactive species, and the amount of the nitrogen-based reactive species was controlled to be lower or higher than the reference value. This made it possible to supply nitrogen-based reactive species to the surface of the base material in an amount better suited to the intended process.

The examples presented in the embodiments described above were described for facilitating understanding of the invention. The invention should not be construed as being limited to these embodiments.

Industrial Applicability

The present invention can be used as a surface modification method based on nitriding of surfaces of, for example, iron and steel, and titanium. For example, the present invention can be applied to various fields such as nitriding treatments on machine tool parts such as spindles and gears, internal-combustion engine parts such as turbines and fuel injection nozzles, reduction gears of, for example, power shovels, aircraft and automobile parts, and medical parts. Furthermore, the present invention is also industrially useful as a high-density nitrogen-based reactive species supplying method for, for example, MOCVD.

Reference Signs List

| | |
|---|---|
| 1, 105: | nitrogen-based reactive species region |
| 2: | coaxial cable for microwave transmission |
| 3: | microstrip line |
| 4: | dielectric substrate |
| 5, 55: | base material |
| 6, 54: | base material table |
| 7: | nozzle |
| 8: | gas evacuation pipe |
| 9: | gas introducing pipe |
| 10: | chamber |
| 11: | microwave introducing flange |
| 12: | gas introducing flange |
| 13: | reactive species measuring unit |
| 50: | microwave |
| 51: | gas 1 |
| 52: | gas 2 |
| 53: | gas evacuation portion |
| 104: | chamber for a large area |
| 106: | plasma source |

**Claims**

1. A nitrogen compound producing method for producing a nitrogen compound by generating a microwave plasma, the nitrogen compound producing method comprising:

    jetting a material gas containing a nitrogen-based gas onto a surface of a base material from a nozzle under flow rate control while applying a microwave to the material gas to thereby irradiate the surface of the base material with a plasma containing nitrogen-based reactive species generated from the material gas,
    wherein a pressure in the jetting is set higher than a pressure at which a mean free path of ions in the plasma is shorter than Debye length.

2. The nitrogen compound producing method according to claim 1,
wherein a microstrip line or a strip line is used as a microwave transmission line for application of the microwave.

3. The nitrogen compound producing method according to claim 1 or 2,
wherein the nozzle is arranged to have a line shape to thereby irradiate the base material with the plasma in a line shape and form a nitrogen compound in a line shape on the surface of the base material.

4. The nitrogen compound producing method according to any one of claims 1 to 3,
wherein in the jetting the material gas from the nozzle, the material gas is jetted at a jetting angle in a range of ±45 degrees from a plane perpendicular to the base material.

5. The nitrogen compound producing method according to any one of claims 1 to 4,
   wherein the pressure in the jetting is set to 1 kPa or higher.

6. The nitrogen compound producing method according to any one of claims 1 to 5,
   wherein a feeding energy for feeding the microwave is 500 watts or lower.

7. The nitrogen compound producing method according to any one of claims 1 to 6, the nitrogen compound producing method comprising:
   arranging 2 or more of the nozzle in an overlapping manner and jetting the material gas containing the nitrogen-based gas onto the surface of the base material from each of the nozzles under flow rate control while applying the microwave to the material gas to thereby generate the plasma containing the nitrogen-based reactive species from the material gas and irradiate the surface of the base material with the plasma,

8. The nitrogen compound producing method according to any one of claim 1 to 7,
   wherein the base material is Ti and the nitrogen compound is TiN.

9. The nitrogen compound producing method according to any one of claims 1 to 7,
   wherein the nitrogen compound producing method epitaxially grows a thin-film crystal of a nitrogen compound formed of any one of GaN, InGaN, InN, and AlN, and a mixture composition thereof on the base material at a low temperature of 700 degrees C or lower, by transporting Ga, In, or Al in a form of an organometallic vapor and allowing the organometallic vapor to undergo a reaction with the plasma containing the nitrogen-based reactive species generated from the material gas in a gas phase or over a substrate.

10. The nitrogen compound producing method according to any one of claims 1 to 9,
    wherein a nitrogen-based reactive species measuring unit and a control unit are provided, and
    wherein the nitrogen compound producing method performs control based on measurement of an amount of the nitrogen-based reactive species.

11. An apparatus configured to produce a nitrogen compound by generating a microwave plasma, the apparatus comprising:

    a chamber;
    a microwave plasma generating apparatus that is provided in the chamber and comprises a nozzle;

a nitrogen-based reactive species measuring unit; and
a control unit,
wherein in jetting a material gas containing a nitrogen-based gas onto a surface of a base material from the nozzle under flow rate control while applying a microwave to the material gas to thereby irradiate the surface of the base material with a plasma containing nitrogen-based reactive species generated from the material gas, the control unit is configured to control a pressure in the chamber to be higher than a pressure at which a mean free path of ions in the plasma is shorter than Debye length, based on measurement of an amount of the nitrogen-based reactive species.

# FIG. 1

Gas evacuation                    Gas evacuation

# FIG. 2A

# FIG. 2B

# FIG. 2C

# FIG. 3

# FIG. 4A

# FIG. 4B

# FIG. 5

# FIG. 6

Line spectra of TiN

# FIG. 7

# FIG. 8

Plasma source 106

**INTERNATIONAL SEARCH REPORT**

| | International application No. |
| --- | --- |
| | PCT/JP2016/082629 |

### A. CLASSIFICATION OF SUBJECT MATTER

*C23C8/36*(2006.01)i, *C23C16/34*(2006.01)i, *C23C16/511*(2006.01)i, *C30B25/18*
(2006.01)i, *C30B29/38*(2006.01)i, *H05H1/30*(2006.01)i

According to International Patent Classification (IPC) or to both national classification and IPC

### B. FIELDS SEARCHED

Minimum documentation searched (classification system followed by classification symbols)
C23C8/36, C23C16/34, C23C16/511, C30B25/18, C30B29/38, H05H1/30

Documentation searched other than minimum documentation to the extent that such documents are included in the fields searched
Jitsuyo Shinan Koho      1922-1996   Jitsuyo Shinan Toroku Koho   1996-2016
Kokai Jitsuyo Shinan Koho  1971-2016   Toroku Jitsuyo Shinan Koho   1994-2016

Electronic data base consulted during the international search (name of data base and, where practicable, search terms used)
JSTPlus(JDreamIII)

### C. DOCUMENTS CONSIDERED TO BE RELEVANT

| Category* | Citation of document, with indication, where appropriate, of the relevant passages | Relevant to claim No. |
| --- | --- | --- |
| Y | JP 2008-515175 A  (Gallium Enterprises Pty Ltd.), 08 May 2008 (08.05.2008), claim 1; paragraphs [0001], [0029] to [0412]; fig. 12a, 12b & US 2008/0272463 A1 claim 1; paragraphs [0026] to [0524]; fig. 12a, 12b & WO 2006/034540 A1    & EP 2573206 A1 & KR 10-2007-0103363 A  & CN 101124353 A & CA 2581626 A | 1-11 |
| Y | JP 5-33120 A  (Sumitomo Heavy Industries, Ltd.), 09 February 1993 (09.02.1993), paragraph [0012] (Family: none) | 1-11 |

| ☒ Further documents are listed in the continuation of Box C. | ☐ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 19 December 2016 (19.12.16) | 27 December 2016 (27.12.16) |

| Name and mailing address of the ISA/ | Authorized officer |
| --- | --- |
| Japan Patent Office 3-4-3,Kasumigaseki,Chiyoda-ku, Tokyo 100-8915,Japan | |
| | Telephone No. |

Form PCT/ISA/210 (second sheet) (January 2015)

**INTERNATIONAL SEARCH REPORT**

International application No.

PCT/JP2016/082629

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2015/030191 A1 (National Institute of Advanced Industrial Science and Technology), 05 March 2015 (05.03.2015), paragraphs [0001], [0027], [0029] to [0097]; fig. 1 to 19 & US 2016/0217979 A1 paragraphs [0054] to [0128]; fig. 1 to 19 & EP 3041324 A1 & KR 10-2016-0048194 A & CN 105684558 A | 2-7,9-11 |
| Y | JP 2015-510263 A (Novellus Systems, Inc.), 02 April 2015 (02.04.2015), claim 24; paragraph [0091] & US 2011/0256724 A1 paragraph [0006] & WO 2013/112727 A1 & KR 10-2013-0086989 A & CN 104081505 A | 10-11 |
| Y | JP 2008-4540 A (Toyota Central Research and Development Laboratories, Inc.), 10 January 2008 (10.01.2008), paragraphs [0037] to [0047] & US 2009/0169968 A1 paragraphs [0048] to [0059] & WO 2007/136131 A1 & EP 2020400 A1 & CN 101448740 A | 10-11 |
| Y | JP 2006-100246 A (Nissan Motor Co., Ltd.), 13 April 2006 (13.04.2006), claims 1, 3, 12, 13 & US 2007/0243429 A1 claims 1, 3, 14, 15 & WO 2005/101555 A1 | 8 |

Form PCT/ISA/210 (continuation of second sheet) (January 2015)

**REFERENCES CITED IN THE DESCRIPTION**

**Patent documents cited in the description**

- JP 2013249524 A
- JP 8035053 A
- WO 2015030191 A

**Non-patent literature cited in the description**

- **YUKI YOSHIMITSU.** Synthesis of Nitride Thin Films of Ti-6Al-4V using Atmospheric- Pressure Plasma. Institute of Electrical Engineers of Japan, plasma researcher's society, 2014, 1-4
- **JAEHO KIM.** *Jpn. J. Appl. Phys.,* 2015, vol. 54, 10AA02